# EUROPEAN PATENT SPECIFICATION

(11) **EP 2 950 625 B1**
(45) Date of publication and mention of the grant of the patent: **09.01.2019**
(21) Application number: 15163724.6
(22) Date of filing: 15.04.2015
(51) Int. Cl.: H05K 7/20

(54) **ELECTRIC APPARATUS**
ELEKTRISCHE VORRICHTUNG
APPAREIL ÉLECTRIQUE

(30) Priority: 30.05.2014 JP 2014112337
(43) Date of publication of application: 02.12.2015
(73) Proprietor: Sansha Electric Manufacturing Company, Limited, Osaka-shi, Osaka 5330031 (JP)
(72) Inventor: Kaneko, Masayuki, Osaka, Osaka 533-0031 (JP)
(74) Representative: Hedges, Martin Nicholas

(56) References cited:
- EP-A1- 0 686 991
- EP-A2- 2 293 658
- CH-A- 546 481
- JP-A- H08 118 170
- US-A- 6 082 441
- US-A1- 2005 286 226
- US-A1- 2007 247 817

## Description

### Technical Field

This invention relates to an electric apparatus and, more particularly, to an electric apparatus with a cooling arrangement for cooling a component which needs to be cooled.

### Background Art

Some electric apparatuses, e.g. power supply apparatuses, include power semiconductor devices and a control circuit for controlling such power semiconductor devices. When operating, such power semiconductor devices and control circuit generate heat, and, therefore, need to be cooled. An example of such cooling arrangement is disclosed in JP 2012-164939A. According to the technology disclosed in JP 2012-164939A, a circuit module which generates heat is disposed within a casing. The circuit module is thermally coupled to a heat sink and is covered by a cover, excluding the portion thereof thermally coupled to the heat sink. In other words, the heat sink, except for the portion thereof to which the circuit module is thermally coupled, is exposed to the interior of the casing. The interior of the casing is partitioned to provide first and second ventilation paths therein. The heat sink is disposed in the first ventilation path, and the cover is disposed in the second ventilation path. A fan is provided in the casing to make cooling air flow through the first and second ventilation paths.

By the use of the above-described technique, it is possible to cool the circuit module and, at the same time, prevent the circuit module from being exposed to dust. This technique, therefore, is suitable for use in a dusty environment. On the other hand, when it becomes necessary to do inspection and maintenance of the circuit module, which is lying under the cover, the cover must be removed. Such inspection and maintenance working is troublesome.

JP H08 118170, which is considered to represent the closest prior art, discloses an electric apparatus comprising a casing having its interior divided into a dust-proof region and an open region, said casing having a first opening formed in a portion of said dust-proof region, a cover plate, and a heat sink, wherein said cover plate is detachable with respect to said first opening, a ventilation hole is formed through said cover plate, and a ventilation path forming member is mounted on an inner surface of said cover plate, said ventilation path forming member forming a ventilation path in an interior thereof through which air flowing through said ventilation hole flows, said ventilation path forming member including a heat-conductive cover rear wall, said cover rear wall being spaced from said inner surface of said cover plate so that a ventilation path is formed between said cover plate and said cover rear wall. wherein the ventilation hole is formed through said cover plate to communicate with said ventilation path.

Other prior art includes CH546481, US2005/286226, EP2293658, US2007/247817, US6082441 and EP0686991.

An object of this invention is to provide electric apparatuses of which components which requires cooling (hereinafter referred to as "cooling-requiring component(s)) are prevented from being exposed to dust when they are cooled, and, at the same time, access to the components for inspection and maintenance is easy.

According to the present invention there is provided an electric al apparatus according to claim 1.

An electric apparatus includes a casing which is partitioned into a dust-proof region and an open region. For example, the dust-proof region may be formed by a partition wall partitioning the interior of the casing, side walls of the casing, and a cover plate which is to be described later. A first opening is formed in a portion of the dust-proof region. The shape of the first opening can be determined freely and may be, for example, rectangular or circular. The cover plate covers or closes the first opening. The cover plate is similar in shape to the first opening. A heat sink is disposed in the dust-proof region in the casing. Within the heat sink, there are disposed components necessary to be cooled, such as a power semiconductor device, a control circuit for the power semiconductor device, an inductor, and a capacitor, for example. The heat sink has a second opening, which opens toward the first-opening side of the casing. The heat sink may be box-shaped, for example. The heat sink may be formed separately from the casing and disposed within the dust-proof region, or may be formed by partitioning the interior of the dust-proof region in the casing with a partition. The cover plate is provided with a ventilation hole, through which air can flow into and/or out of the casing. A ventilation path forming member is mounted on the inner surface of the cover plate. In the interior of the ventilation path forming member, a ventilation path is formed, through which air flowing through the ventilation hole flows. At least part of the outer surface of the ventilation path forming member covers the second opening. The ventilation path forming member is made of a heat conductive material.

The second opening of the heat sink disposed in the dust-proof region in the casing of an electric apparatus having the above-described structure is covered by at least a part of the ventilation path forming member. Thus, the interior of the heat sink within the dust-proof region is also dust-proof, and, therefore, the cooling-requiring components within the heat sink are never exposed to dust. Furthermore, the heat generated by the cooling-requiring component disposed within the heat sink is transmitted to the ventilation path because the second opening in the heat sink is covered by at least a part of the ventilation path forming member. Air from the ventilation hole flows through the ventilation path, cooling the cooling-requiring components. Since the ventilation path forming member is fitted to the cover plate, the ventilation path forming member can be detached from the second opening in the heat sink by detaching the cover plate from the first opening, whereby the dust-proof region and the heat sink disposed therein are exposed. Thus, access to the dust-proof region, the heat sink and the cooling-requiring components for inspection and maintenance is made easily by simply removing the cover plate.

The casing may be in the shape of rectangular parallelepiped. In such case, one of the sides of the casing is opened to provide the first opening. Then, the cover plate is a side wall closing the first opening.

By employing this structure, access to not only the components in the heat sink but also components in the dust-proof region other than in the heat sink for inspection and maintenance thereof is further facilitated by removing the side wall of the casing.

Other cooling-requiring components mounted on at least one second heat sink different from the above-described one may be disposed within the casing. These other cooling-requiring components may be disposed in the open region, for example. In this case, a fan is disposed within the casing for cooling the above-described heat sink and the second heat sink. The fan is disposed near the ventilation path forming member within the casing.

With this arrangement, even if pressure loss in the ventilation path is large, the fan provides cooling air through the ventilation path, which makes it sure for the cooling-requiring components in the heat sink to be cooled definitely.

The ventilation path forming member may have a third opening at its one end which communicates with the open region in the casing. In such structure, the ventilation hole is located near to the other end of the ventilation path forming member.

With this arrangement, air flows between the outside of the casing and the open region, through the first opening, the ventilation path and the third opening, and, therefore, that portion of the ventilation path forming member which closes the second opening in the heat sink can be efficiently cooled. Thus, the cooling-requiring components in the heat sink can be cooled with a high efficiency.

A support plate disposed within the dust-proof region, e.g. a support plate for the heat sink, may be provided with a cut into which at least part of the outer surface of the ventilation path forming member can be inserted so as to close the second opening.

With such arrangement, the cut functions as a member for positioning the ventilation path forming member, which enables the ventilation path forming member to intimately contact with the second opening, resulting in improvement of the thermal efficiency. Furthermore, since the ventilation path forming member is placed in the cut, the gap between the dust-proof region and the open region is filled up, and, therefore, dust cannot enter into the dust-proof region. Thus, the electric apparatus is resistant to the environment, with the interior of the heat sink never exposed to such dust.

### Brief Description of Drawings

Fig. 1 shows a longitudinal cross-section of an electric apparatus seen from the rear side thereof according to a first embodiment of the present invention.
1.Fig. 2 is an exploded perspective view of the electric apparatus of Fig.
Fig. 3 is an enlarged plan view of part of the electric apparatus of Fig. 1.
Fig. 4 shows a longitudinal cross-section of an electric apparatus seen from the rear side thereof according to a second embodiment of the present invention.

### Description of Embodiments

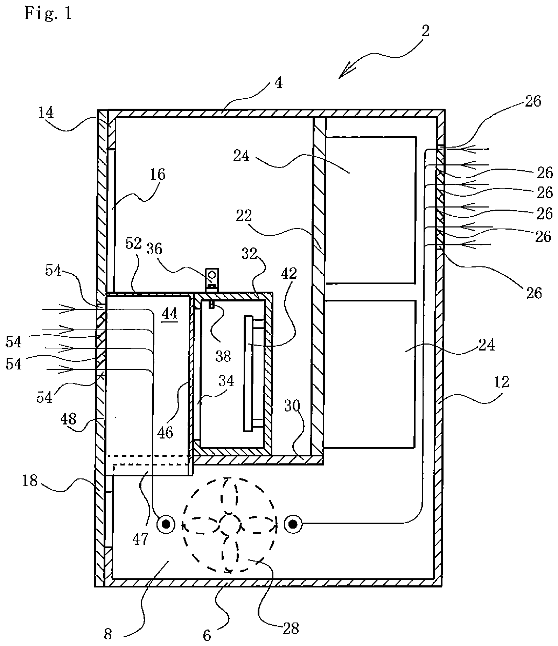

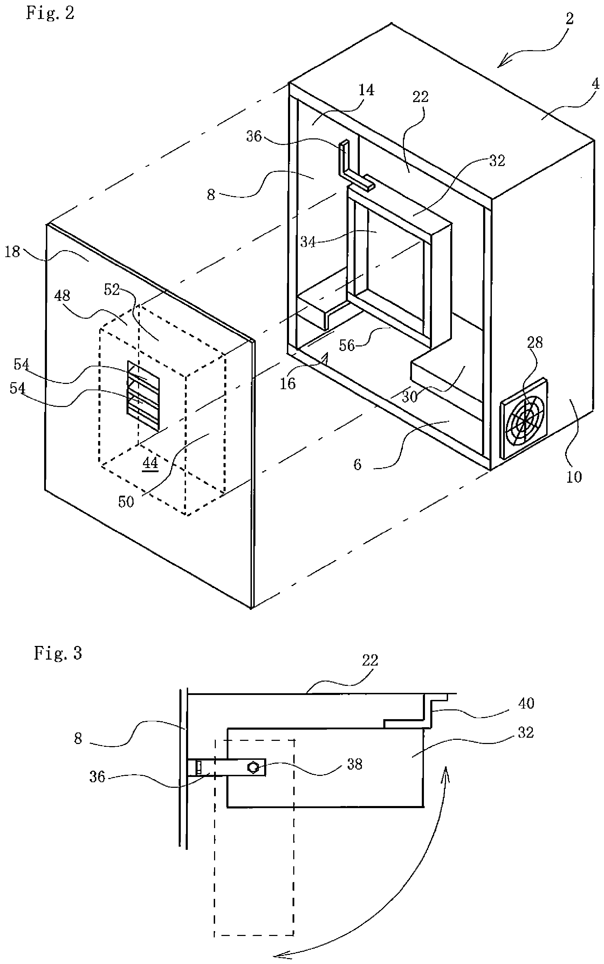

An electric apparatus according to a first embodiment of the present invention is, for example, a power supply apparatus for use with, for example, a welder. As shown in Figs. 1 and 2, the electric apparatus has a casing 2, which may be formed of metal and is shaped into a generally rectangular parallelepiped, for example. The casing 2 includes a top wall 4, a bottom wall 6, a front wall 8, a rear wall 10, and side walls 12 and 14. The side wall 14 is formed into a frame-like shape, with a first opening, e.g. a rectangular side-wall opening 16, formed therein. A cover plate, e.g. a side-wall plate 18, is detachably fitted to the side wall 14 to thereby cover the side-wall opening 16. The side-wall plate 18 has a size same as that of the side wall 14.

As shown in Figs. 1 and 2, a partition wall 22 is disposed to extend from the front wall 8 to the rear wall 10 at a location in the casing 2 nearer to the side wall 12. The partition wall 22 is in contact with the top wall 4 but not with the bottom wall 6. A support plate 30 extends horizontally from the lower end of the partition wall 22 to the side-wall plate 18. As is seen in Fig. 2, the support plate 30 extends between the front wall 8 and the rear wall 10. A region surrounded or defined by the front wall 8, the rear wall 10, the partition wall 22 and the support plate 30 is a dust-proof region, and the remaining region within the casing 2 is an open region.

Plural, two, for example, heat sinks 24 are mounted on that surface of the partition wall 22 which faces the side wall 12. The heat sinks 24 are arranged on the partition wall 22 in a direction from the top wall 4 toward the bottom wall 6, or, in other words, in the vertical direction. Although not shown, cooling-requiring components, e.g. power semiconductor devices, to be used in the power supply apparatus, are thermally coupled to the heat sinks 24. Although not shown, windows are formed in the partition wall 22, through which one surface of each heat sink 24 can be exposed to the dust-proof region. The power semiconductor devices are mounted on the exposed surfaces of the heat sinks 24 in the windows. The heat sinks 24 are disposed being spaced from the side wall 12, and ventilation holes 26 are formed through the side wall 12 for the upper one of the heat sinks 24. The ventilation holes 26 are elongated in shape in the horizontal direction, and plural ones of the ventilation holes 26 are vertically arranged. Plural groups of such vertically arranged ventilation holes 26 are arranged in the horizontal direction or along horizontal lines extending between the front wall 8 and the rear wall 10.

Air supplying means, e.g. a fan 28, is fitted to the rear wall 10 at a location lower than the lower end of the partition wall, as shown in Fig. 2. When the fan 28 is operated, air is introduced through the ventilation holes 26 into the interior of the casing 2 as indicated by thin lines in Fig. 1. The air introduced in this way flows through the heat sinks 24, advances rearward and is discharged out of the casing 2 by the action of the fan 28. The air flowing through the heat sinks 24 cools the components including power semiconductor devices mounted on the heat sinks 24. The fan 28 is fitted to the rear wall 10 and, therefore, should not be shown in Fig. 1, but it is indicated by phantom lines in Fig. 1 to show the location of the fan 28 on the rear wall 10.

Although not shown, other cooling-requiring components other than power semiconductor devices of the power supply apparatus are also mounted on the surface of the partition wall 22 within the dust-proof region.

Also, a heat sink 32 is fitted to the support plate 30 within the dust-proof region. The heat sink 32 is spaced from the partition wall 22 and also from the side-wall opening 16 in the side wall 14. The heat sink 32 has a shape of a hollow, vertically elongated box, for example, and has an opening 34 in the side facing the side wall 14. The shape of the opening 34 is rectangular, for example.

The heat sink 32, as shown being enlarged in Fig. 3, is rotatable about a rotation shaft, e.g. a vertically extending bolt 38, fitted to the horizontal portion of an angle 36 fixed to the front wall 8. Thus, the heat sink 32 is rotatable about the bolt 38 over an angle of 90 degrees indicated by an arrowed line in Fig. 3. This arrangement facilitates access, for inspection and maintenance, to those components mounted on portions of the partition wall 22 hidden by the heat sink 32 in the position indicated by solid lines in Figs. 1-3. A stopping member 40 for stopping the heat sink 32 is fixed to the partition wall 22.

As shown in Fig. 1, a base plate 42 is fixed to the wall within the heat sink 32 facing to the rectangular opening 34. Components, such as integrated circuits providing control circuits for cooling-requiring components, e.g. power semiconductor devices, are mounted on the base plate 42. These components do not extend out of the rectangular opening 34 but remain within the heat sink 32. These components should not be exposed to dust and any other foreign materials. Inspection and maintenance for the components disposed on the base plate 42 from the exterior of the casing 2 can be made through the rectangular opening 34 and the side-wall opening 16.

On the inner surface of the side-wall plate 18, a ventilation path forming member 44 is disposed. The ventilation path forming member 44 includes a cover member, e.g. a cover rear wall 46. With the side-wall plate 18 secured to the side wall 14 to close the side-wall opening 16, the cover rear wall 46 is located being spaced from the inner surface of the side wall 14 so as to entirely close the rectangular opening 34 in the heat sink 32. The cover rear wall 46 tightly closes the heat sink 32. Rectangular cover side walls 48 and 50 extend from the respective side edges of the cover rear wall 46 to the inner surface of the side-wall plate 18. A rectangular cover upper wall 52 extends from the upper edge of the cover rear wall 46 to the inner surface of the side-wall plate 18. The space defined by the cover rear wall 46, the cover side walls 48 and 50, the cover upper wall 52 and the side-wall plate 18 form a rectangular parallelepiped ventilation path having a third opening, e.g. a lower opening 47, at the lower end of the ventilation path. Through this lower opening 47, the ventilation path opens onto the open region of the casing 2. The lower opening 47 is located lower than the support plate 30. The cover rear wall 46, the cover side walls 48 and 50, the cover upper wall 52 are formed integral with each other and formed of heat conductive material, e.g. metal. The edges of the cover rear wall 46, the cover side walls 48 and 50, the cover upper wall 52 which are in contact with the inner surface of the side-wall plate 18 are fixed to the side-wall plate 18 by, for example, welding. Accordingly, the ventilation path forming member 44 moves with the side-wall plate 18 when the side-wall plate 18 is moved.

A plurality of ventilation holes 54 are formed through a portion of the side-wall plate 18 facing the upper portion of the cover rear wall 46, so that the ventilation holes 54 are located in an upper portion of the ventilation path provided by the ventilation path forming member 44. The ventilation holes 54 are spaced from adjacent ones in the vertical direction. In fact, the fan 28 is disposed at a location on the rear wall 10 (not shown in Fig. 1) near to the lower opening 47 of the ventilation path forming member 44 as indicated by phantom lines in Fig. 1. Thus, when the fan 28 is driven, air is introduced into the ventilation path through the ventilation holes 54, flows from the upper portion to the lower portion of the cover rear wall 46 into the open region of the casing 2 through the lower opening 47, and is discharged out of the casing 2 by the action of the fan 28. The heat generated by the components on the base plate 42 in the heat sink 32 is transmitted to the cover rear wall 46. Since the cover rear wall 46 is exposed to the above-mentioned air flow, the components on the base plate 42 in the heat sink 32 are cooled. The fan 28 is located near the ventilation path forming member 44, and therefore the introduced air can flow along the cover rear wall 46 from its upper portion to the lower portion even if the pressure loss in the ventilation path formed by the ventilation path forming member 44 is large. Thus, the components in the heat sink 32 can be cooled well.

As is seen in Fig. 2, a notch or cut is formed to extend into the support plate 30 from the edge thereof facing the side-wall opening 16. The depth and width of the cut 56 are determined such that, when the side-wall plate 18 is attached to the side wall 14 to thereby close the side-wall opening 16, the cover rear wall 46 and the cover side walls 48 and 50 of the ventilation path forming member 44 are inserted into the casing 2 and can intimately contact the rectangular opening 34 of the heat sink 32. As a result, the cut 56 functions as a positioning member which places the ventilation path forming member 44 in position relative to the heat sink 32. By attaching the side-wall plate 18 in position to thereby put a portion of the ventilation path forming member 44 into the cut 56, the region surrounded by the cover upper wall 52, the side wall 14, the top wall 4, the partition 22, the support plate 30, the front wall 8 and the rear wall 10 becomes a dust-proof region, which is not exposed to dust. As described above, the ventilation path forming member 44 has the third opening, such as the ventilation hole 47, at a location lower than the location of the support plate 30, whereby the ventilation path forming member 44 communicates with the region in the casing 2 other than the dust-proof region, i.e. the open region. Accordingly, the air introduced by the action of the fan 28 flows through the ventilation holes 54 and the opening 47 over the fan 28. Thus, the fan 28 can supply cooling air singly to both of the dust-proof region and the open region.

Although not shown in Figs. 1 and 2, other components of the power supply apparatus are mounted on the upper surface of the heat sink 32 and/or on the lower surface of the support plate 30.

With the above-described arrangement of the power supply apparatus, when the fan 28 is driven in the manner stated above, the power semiconductor devices on the heat sinks 24 are cooled, and, further, the components on the base plate 42 in the heat sink 32 are also cooled. The region surrounded by the cover upper wall 52, the side-wall plate 18, the side wall 14, the top wall 4, the partition 22, the support plate 30, the front wall 8 and the rear wall 10 provide the dust-proof region, which is not exposed to dust. Furthermore, since the heat sink 32 is tightly closed by the cover rear wall 46 of the ventilation path forming member 44, dust does not enter into the heat sink 32. The ventilation path forming member 44 is mounted on the inner surface of the side-wall plate 18, and, therefore, when the side-wall plate 18 is detached, the rectangular opening 34 in the heat sink 32 becomes accessible through the side-wall opening 16. Thus, maintenance and inspection of the components in the heat sink 32 can be readily carried out from outside the casing 2. In particular, access to the heat sink 32 for inspection and maintenance can be made by removing the side-wall plate 18 of the casing 2, which is easier than access to the heat sink 32 made by removing, for example, the top wall 4. Further, since the heat sink 32 is rotatable about the bolt 38, access to the components behind the heat sink 32 for inspection and maintenance is easy. Also, the rectangular opening 34 in the heat sink 32 can be tightly closed by the cover rear wall 46 of the ventilation path forming member 44, which is put into the cut 56 in the support plate 30 when the side-wall plate 18 is attached to close the side-wall opening 16. Thus, dust and foreign materials can hardly enter into the heat sink 32.

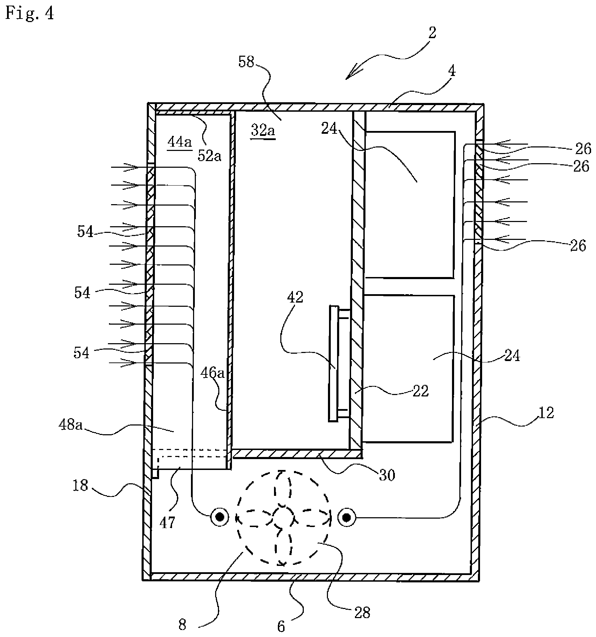

Fig. 4 shows a power supply apparatus according to a second embodiment of the present invention. Only those components which are different from the equivalent components in the power supply apparatus according to the first embodiment shown in Figs. 1-3 are shown with a suffix "a" attached to the reference numerals used for the equivalent components. The power supply apparatus according to the second embodiment includes a heat sink 32a. The heat sink 32a is formed by disposing two side walls 58 (only one of the two being shown) which are spaced from each other in the direction perpendicular to the plane of the sheet of Fig. 4 and extend to the top wall 4 of the casing 2. The two side walls 58 are secured to the support plate 30, the partition wall 22 and the top wall 4. The heat sink 32a has a rectangular opening on the side facing the ventilation holes 54. A ventilation path forming member 44a has a rear wall 46a which extends from the top wall 4 of the casing 2 to a location beyond the lower surface of the support plate 30 to completely cover the rectangular opening of the heat sink 32a. The ventilation path forming member 44a has an upper wall 52a which is in contact with the top wall 4 of the casing 2. The ventilation path forming member 44a also has side walls 48a and 50a which are in contact with the rear wall 46a and the upper wall 52a. (Only the side wall 48a is shown in Fig. 4.) A larger number of the ventilation holes are formed in the sidewall plate 18 because the length of the rear wall 46a is larger than the length of the rear wall 46 of the ventilation path forming member 44 of the first embodiment. Also, according to the second embodiment, the frame-shaped side wall 14 used in the power supply apparatus according to the first embodiment is not used. As in the power supply apparatus according to the first embodiment, the base plate 42 is disposed in the heat sink 32a. The remainder of the structure is the same as the power supply apparatus according to the first embodiment, and therefore they are not described further. The power supply apparatus according to the second embodiment operates in a manner similar to the one according to the first embodiment.

The present invention has been described as being embodied in power supply apparatuses, but it can be embodied in any other electric apparatuses employing cooling-requiring components, such as electric power apparatuses and desk-top personal computers. In the apparatuses according to the first and second embodiments, the first opening 16 is formed in one of the side walls of the casing 2, but it may be formed in the top wall 4 or in the rear wall 10, for example. (If the first opening 16 is formed in the rear wall 10, the fan 28 may be removed to other appropriate location to provide an efficient air flow.) The casing 2 according to the described two embodiments has been described to have a shape of a rectangular parallelepiped, but other shape, such as cylindrical or polygonal columnar shape, may be employed. In the described power supply apparatuses, the heat sinks 24 are used to cool components thereon in addition to the components in the heat sink 32, but the cooling-requiring components may be disposed only in the heat sink 32.

According to the first embodiment, the dust-proof region is formed by the cover upper wall 52, the side wall plate 18, the side wall 14, the top wall 4, the partition wall 22, the support plate 30, the front wall 8 and the rear wall 10, but the dust-proof region may be formed by using other techniques. For example, a box having the second opening may be disposed within the casing 2 with the second opening facing the first opening, to thereby form the dust-proof region. Although the heat sink 32 of the power supply apparatus according to the first embodiment has been described as having a shape of vertically elongated box with a rectangular opening, but the shape is not limited to it. The shape of the heat sink 32 may be a cylinder having a circular opening, or a polygonal column having a polygonal opening, such as a triangular or pentagonal opening. When a heat sink of such shape is used, the heat sink is oriented in such a manner that its opening faces the side-wall opening 16. The heat sink 32 has been described as being a member separate from the support plate 30, but a part of the support plate 30 may be used as a part of the heat sink 32 when it is not necessary for the heat sink 32 to be rotated about the bolt 38. Further, the ventilation path forming member 44 has been described as having the entire cover rear wall 46 covering the rectangular opening 34 of the heat sink 32, but the vertical dimension of the ventilation path forming member 44 may be increased so that the cover upper wall 52 is nearer to the top wall 4 of the casing 2 with only part of the cover rear wall 46 tightly closing the rectangular opening 34. Also, the cover upper wall 52 may be formed to extend upward from the cover rear wall 46 slantwise toward the side-wall plate 18. Further, the cover side walls 48 and 50 may be formed to extend from the opposing side edges of the cover rear wall 46 slantwise toward the side-wall plate 18 with the distances between the cover side-walls 48 and 50 and the front and rear walls 8 and 10, respectively, decreasing as nearing to the side-wall plate 18.

## Claims

1. An electric apparatus comprising:
a casing (2) having its interior divided into a dust-proof region and an open region, said casing having a first opening (16) formed in a portion of said dust-proof region;
a cover plate (18); and
a heat sink (32, 32a);
wherein said cover plate (18) is detachable with respect to said first opening (16);
a ventilation hole (54) is formed through said cover plate (18); and
a ventilation path forming member (44, 44a) is mounted on an inner surface of said cover plate (18), said ventilation path forming member (44, 44a) forming a ventilation path in an interior thereof through which air flowing through said ventilation hole (54) flows, said ventilation path forming member (44, 44a) including a heat-conductive cover rear wall (46, 46a), said cover rear wall being spaced from said inner surface of said cover plate so that the ventilation path is formed between said cover plate and said cover rear wall;
wherein the ventilation hole (54) is formed through said cover plate (18) to communicate with said ventilation path; **characterised in that**:
the cover plate (18) covers said first opening (16);
the heat sink (32, 32a) is disposed in said dust-proof region of said casing (2);
the cooling-requiring components are mounted within said heat sink (32, 32a);
said heat sink (32, 32a) has a second opening (34) facing said first opening (16), and
the heat-conductive cover rear wall (46, 46a) closes said second opening (34) when said cover plate (16) covers said first opening (16).

2. An electric apparatus according to Claim 1 wherein said heat sink is box-shaped.

3. An electric apparatus according to Claim 1 wherein said heat sink is formed by partitioning said dust-proof region.

4. An electric apparatus according to Claim 1 wherein said casing is rectangular parallelepiped shaped and has one of side surfaces thereof opened to provide said first opening; and said cover plate is a side plate covering said first opening.

5. An electric apparatus according to Claim 1 wherein cooling-requiring components different from said cooling-requiring components referred to in Claim 1 are mounted on a heat sink different from said heat sink referred to in Claim 1; a fan for cooling said heat sinks is disposed within said casing in the vicinity of said ventilation path forming member.

6. An electric apparatus according to Claim 1 wherein said ventilation path forming member includes a third opening in one end portion thereof, said third opening communicating with said open region; and said ventilation hole is formed at a location where the other end of said ventilation path forming member is located.

7. An electric apparatus according to Claim 1 wherein said dust-proof region is surrounded by walls including a support plate, a cut being formed in said support plate in such a form that at least a part of an outer surface of said ventilation path forming member can be inserted into said cut to thereby close said second opening.

## Patentansprüche

1. Elektrische Vorrichtung, umfassend:
ein Gehäuse (2), dessen Innenraum in einen staubdichten Bereich und einen offenen Bereich unterteilt ist, wobei das Gehäuse eine erste Öffnung (16) aufweist, die in einem Abschnitt des staubdichten Bereichs ausgebildet ist;
eine Abdeckplatte (18); und
einen Kühlkörper (32, 32a);
wobei die Abdeckplatte (18) in Bezug auf die erste Öffnung (16) abnehmbar ist;
eine Lüftungsöffnung (54) durch die Abdeckplatte (18) gebildet ist; und
ein Lüftungsweg-Ausbildungselement (44, 44a) an einer Innenfläche der Abdeckplatte (18) angebracht ist, wobei das Lüftungsweg-Ausbildungselement (44, 44a) in seinem Inneren einen Lüftungsweg bildet, durch den Luft durch die Lüftungsöffnung (54) strömt, wobei das Lüftungsweg-Ausbildungselement (44, 44a) eine wärmeleitende Abdeckungsrückwand (46, 46a) beinhaltet, wobei die Abdeckungsrückwand von der Innenfläche der Abdeckplatte beabstandet ist, sodass der Lüftungsweg zwischen der Abdeckplatte und der Abdeckungsrückwand gebildet wird;
wobei die Lüftungsöffnung (54) durch die Abdeckplatte (18) gebildet ist, um mit dem Lüftungsweg zu kommunizieren; **dadurch gekennzeichnet, dass**:
die Abdeckplatte (18) die erste Öffnung (16) abdeckt;
der Kühlkörper (32, 32a) in dem staubdichten Bereich des Gehäuses (2) angeordnet ist;
die zur Kühlung erforderlichen Komponenten innerhalb des Kühlkörpers (32, 32a) montiert sind;
der Kühlkörper (32, 32a) eine zweite Öffnung (34) aufweist, die der ersten Öffnung (16) zugewandt ist, und
die wärmeleitende Abdeckungsrückwand (46, 46a) die zweite Öffnung (34) schließt, wenn die Abdeckplatte (16) die erste Öffnung (16) abdeckt.

2. Elektrische Vorrichtung nach Anspruch 1, wobei der Kühlkörper kastenförmig ist.

3. Elektrische Vorrichtung nach Anspruch 1, wobei der Kühlkörper durch Unterteilung des staubdichten Bereichs gebildet wird.

4. Elektrische Vorrichtung nach Anspruch 1, wobei das Gehäuse eine rechteckige Parallelepipedform aufweist und eine seiner Seitenflächen geöffnet ist, um die erste Öffnung bereitzustellen; und die Abdeckplatte eine Seitenplatte ist, die die erste Öffnung abdeckt.

5. Elektrische Vorrichtung nach Anspruch 1, wobei zur Kühlung erforderliche Komponenten, die sich von den in Anspruch 1 genannten zur Kühlung erforderlichen Komponenten unterscheiden, auf einem Kühlkörper montiert sind, der sich von dem in Anspruch 1 genannten Kühlkörper unterscheidet; ein Lüfter zum Kühlen der Kühlkörper ist in dem Gehäuse in der Nähe des Lüftungsweg-Ausbildungselements angeordnet.

6. Elektrische Vorrichtung nach Anspruch 1, wobei das Lüftungsweg-Ausbildungselement eine dritte Öffnung in einem Endabschnitt davon beinhaltet, wobei die dritte Öffnung mit dem offenen Bereich in Verbindung steht; und die Lüftungsöffnung an einer Stelle ausgebildet ist, an der sich das andere Ende des Lüftungsweg-Ausbildungselements befindet.

7. Elektrische Vorrichtung nach Anspruch 1, wobei der staubdichte Bereich von Wänden umgeben ist, die eine Stützplatte beinhalten, wobei in der Stützplatte ein Einschnitt in einer solchen Form ausgebildet ist, dass zumindest ein Teil einer Außenfläche des Lüftungsweg-Ausbildungselements in den Einschnitt eingeführt werden kann, um dadurch die zweite Öffnung zu schließen.

## Revendications

1. Appareil électrique comprenant :
un boîtier (2) dont l'intérieur est divisé en une région étanche à la poussière et une région ouverte, ledit boîtier ayant une première ouverture (16) formée dans une partie de ladite région étanche à la poussière ;
une plaque de couverture (18) ; et
un dissipateur de chaleur (32, 32a) ;
dans lequel ladite plaque de couverture (18) est détachable par rapport à ladite première ouverture (16) ;
un trou de ventilation (54) est formé à travers ladite plaque de couverture (18) ; et
un élément de formation de trajet de ventilation (44, 44a) est monté sur une surface intérieure de ladite plaque de couverture (18), ledit élément de formation de trajet de ventilation (44, 44a) formant un trajet de ventilation dans son intérieur à travers lequel l'air s'écoulant à travers ledit trou de ventilation (54) s'écoule, ledit élément de formation de trajet de ventilation (44, 44a) incluant une paroi arrière de couverture thermoconductrice (46, 46a), ladite paroi arrière de couverture étant espacée de ladite surface intérieure de ladite plaque de couverture de sorte que le trajet de ventilation soit formé entre ladite plaque de couverture et ladite paroi arrière de couverture ;
dans lequel le trou de ventilation (54) est formé à travers ladite plaque de couverture (18) pour communiquer avec ledit trajet de ventilation ; **caractérisé en ce que** :
la plaque de couverture (18) recouvre ladite première ouverture (16) ;
le dissipateur de chaleur (32, 32a) est disposé dans ladite région étanche à la poussière dudit boîtier (2) ;
les composants nécessitant un refroidissement sont montés dans ledit dissipateur de chaleur (32, 32a) ;
ledit dissipateur de chaleur (32, 32a) présente une seconde ouverture (34) faisant face à ladite première ouverture (16), et
la paroi arrière de couverture thermoconductrice (46, 46a) ferme ladite seconde ouverture (34) lorsque ladite plaque de couverture (16) recouvre ladite première ouverture (16).

2. Appareil électrique selon la revendication 1, dans lequel ledit dissipateur de chaleur est en forme de boîte.

3. Appareil électrique selon la revendication 1, dans lequel ledit dissipateur de chaleur est formé en partitionnant ladite région étanche à la poussière.

4. Appareil électrique selon la revendication 1, dans lequel ledit boîtier est en forme de parallélépipède rectangle et a l'une de ses surfaces latérales ouvertes pour fournir ladite première ouverture ; et ladite plaque de couverture est une plaque latérale recouvrant ladite première ouverture.

5. Appareil électrique selon la revendication 1, dans lequel des composants nécessitant un refroidissement différents desdits composants nécessitant un refroidissement visés à la revendication 1 sont montés sur un dissipateur de chaleur différent dudit dissipateur de chaleur mentionné à la revendication 1 ; un ventilateur pour le refroidissement desdits dissipateurs de chaleur est disposé à l'intérieur dudit boîtier au voisinage dudit élément de formation de trajet de ventilation.

6. Appareil électrique selon la revendication 1, dans lequel ledit élément de formation de trajet de ventilation comprend une troisième ouverture dans une partie d'extrémité de celui-ci, ladite troisième ouverture communiquant avec ladite région ouverte ; et ledit trou de ventilation est formé à un emplacement où l'autre extrémité dudit élément de formation de trajet de ventilation est située.

7. Appareil électrique selon la revendication 1, dans lequel ladite région étanche à la poussière est entourée de parois comprenant une plaque de support, une découpe étant formée dans ladite plaque de support sous une forme telle qu'au moins une partie d'une surface extérieure dudit élément de formation de trajet de ventilation puisse être inséré dans ladite découpe pour fermer ainsi ladite seconde ouverture.
